(19) Europäisches Patentamt
European Patent Office
Office européen des brevets

(11) Publication number: **0 425 418 A2**

(12) # EUROPEAN PATENT APPLICATION

(21) Application number: **90480149.5**

(51) Int. Cl.⁵: **G03F 7/038**

(22) Date of filing: **21.09.90**

(30) Priority: **23.10.89 US 425528**

(43) Date of publication of application:
**02.05.91 Bulletin 91/18**

(84) Designated Contracting States:
**DE FR GB**

(71) Applicant: **International Business Machines Corporation**
**Old Orchard Road**
**Armonk, N.Y. 10504(US)**

(72) Inventor: **Conley, Willard Earl**
**16 Chadeayne Avenue**
**Cornwall, New York 12518(US)**
Inventor: **Moreau, Wayne Martin**
**10 Lydia Drive**
**Wappingers Falls, New York 12590(US)**
Inventor: **Spinillo, Gary Thomas**
**23 Valley Road**
**Wappingers Falls, New York 12590(US)**
Inventor: **Gelorme, Jeffrey Donald**
**30 Hemmingway Street**
**Plainville, Connecticut 06062(US)**
Inventor: **Perreault, Stanley Eugene**
**6 Denim Drive**
**Wappingers Falls, New York 12590(US)**
Inventor: **Wood, Robert Lavin**
**6 Argent Drive**
**Poughkeepsie, New York 12603(US)**

(74) Representative: **Klein, Daniel Jacques Henri**
**Compagnie IBM France Département de Propriété Intellectuelle**
**F-06610 La Gaude(FR)**

(54) **Base developable negative tone photoresist.**

(57) Aqueous, base-soluble resist compositions useful for forming negative-tone images. More particularly, the compositions include an aromatic hydroxy-substituted polymeric composition, a radiation degradable acid generator which is adapted to absorb imaging radiation, and a cross-linking agent having at least 2 epoxy groups per molecule.

EP 0 425 418 A2

# BASE DEVELOPABLE NEGATIVE TONE PHOTORESIST

The present invention is concerned with aqueous, base-soluble resist compositions useful for forming negative-tone images. More particularly, the compositions include an aromatic hydroxy-substituted polymeric composition, a radiation degradable acid generator which is adapted to absorb imaging radiation, and a cross-linking agent having at least 2 epoxy groups per molecule.

The use of negative acting photoresists is well known. Originally, such resist systems were based on rubbery, thermoplastic polymers such as cyclized rubber, isoprenoids, various vinyl polymers such as polyvinyl cinnamate and its derivatives, diallyl ester resins such as diallylphthalate, and the like. Typically these materials suffered a number of defects when they were scaled down from platemaking uses to microelectronic processing. Among the process deficiencies noted are (1) the inherent difficulties in obtaining high quality, pinhole-free coatings of good uniformity and adhesion to substrate surfaces, (2) the thermal instability of such materials and the lack of contrast in exposed resists limited the utility of these materials in many semiconductor processes, and (3) the problems of organic solvents in causing image distortion due in great part to resist swelling and the disposal of such solvents from the waste stream.

The use of epoxy novolak resist systems to obtain negative-tone image patterns by means of crosslinking agents is known. These systems have been developable in organic solvents such as propylene glycol methyl acetate (PMA), n-butyl acetate (NBA), isopropyl alcohol (IPA), and like solvents. Images formed with such systems have suffered from various deficiencies including image distortion due to resist swelling in the organic solvent developers.

Additionally, the use of organic solvents provides increased waste management problems due to potential toxicity of the solvents and the difficulties in concentrating the solutions for disposal.

The art recognizing many of these deficiencies has attempted several approaches to provide improved resist systems and their processing. There have been attempts to provide aqueous base developable negative-tone resist systems.

One approach has been to use a novolak or polyhydroxystyrene resin with a bis-azide sensitizer with an aqueous developer such as potassium hydroxide or tetramethyl ammonium hydroxide. These resist systems exhibit low sensitivity, poor resolution, low contrast, and high optical density related problems in deep UV lithography.

Another approach which is set forth in European patent application EP-A-0 232 972 where very complex systems are proposed. In that publication, compositions are disclosed which comprise an acid hardening resin system and a halogenated, organic, photoacid generating compound. Suitable acid hardening resin systems contain a polymer which crosslinks in the presence of an acid catalyst and heat. Such acid hardening resins are typically prepared from a variety of aminoplasts or phenoplasts in combination with compounds or low molecular weight polymers containing a plurality of hydroxyl, carboxyl, amide or imide groups. Included in such aminoplasts are coresins of urea-formaldehyde, melamine-formaldehyde, benzoguanamine-formaldehyde, glycouricil-formaldehyde, and combinations thereof. These aminoplasts are used in combination with reactive hydrogen containing compounds such as novolak resins, polyvinylphenol, polyglutarimide, poly(meth)acrylic acid copolymers, alkali soluble polymethacrylamide copolymers, coploymers containing 2-hydroxyethyl acrylate or methacrylate, polyvinyl alcohols, alkali-soluble styrene-allyl alcohol copolymers. The other active component of such systems is a halogenated, organic, photoacid generating compound. These materials generate a halogen acid upon exposure to actinic radiation, typically have absorption maxima in the range of 210 to 299 nanometers, must be compatible with the acid hardening resin system, be developable in aqueous base, and be capable of generating the halogen acid upon exposure to actinic radiation for crosslinking the acid hardening resin system at elevated temperature to form thermally stable negative images.

It has now been found that greatly improved aqueous base-developable negative-tone resist systems can be prepared using an aromatic hydroxy-substituted polymeric composition, a radiation degradable acid generator which is adapted to absorb imaging radiation, and a cross-linking agent having at least 2 epoxy groups per molecule. Negative-tone resists which have good contrast and sensitivity and which are essentially free from image distortion are realized by this approach.

The compositions of the present invention take advantage of the discovery that certain classes of polyepoxide-containing compounds which undergo ring opening in the presence of strong acid are especially useful in crosslinking hydroxy-containing aromatic resin compositions. Preferred among the polyepoxide crosslinking agents are biscycloaliphatic epoxides such as bis cyclohexene epoxide and glycidyl ethers such as partially epoxidized novolak resins. Typical of such biscyclohexene epoxides is a material sold by Union Carbide and Ciba-Geigy as Araldite CY-179. Suitable epoxy novolaks include ECN

Quattrex 3710 sold by Dow Chemical Company.

The aromatic hydroxy-substituted polymeric composition may be any of the well-known aromatic resins where the hydroxy group is linked to an aromatic ring as a phenolic substituent. The polymeric composition is soluble in aqueous alkaline developers. Included and preferred among such materials are polyhydroxystyrene (especially, poly(para -hydroxystyrene)) and novolaks such as meta -cresol novolak and Bisphenol A novolak.

The radiation sensitive materials are radiation degradable acid generating materials which have sufficient strength to open the epoxide rings so that the hydroxyaromatic functionalities may be crosslinked. These materials include metallic onium salts, nonmetallic onium salts, and non-metallic sulfonic acid precursors which generate strong acids upon exposure to radiation. Onium salts are a well known class of material and include diaryliodonium salts and arylsulfonium salts. Typical of the diaryliodonium salts is di( tert -butylphenyl)iodonium trifluoromethane sulfonate. Aryl sulfonium salts are more commonly used and include triphenylsulfonium hexafluoroantimonate, triphenylsulfonium hexafluoroarsinate, and triphenylsulfonium hexafluorophosphate. Non-metallic sulfonic acid precursors of the type disclosed in EP-A-0 388 343 filed on 02.02.1990 which is incorporated by reference into the instant application. There is disclosed the use of N-sulfonyloxyimides of the form

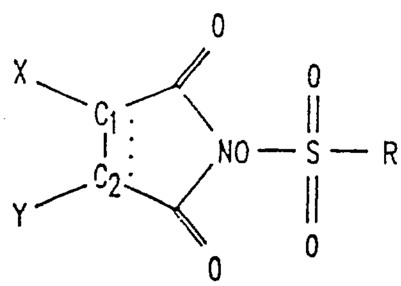

wherein R is selected from the group consisting of $-CF_3$, $-CF_2CF_3$, $-CF_2CF_2H$,$-(CF_2)_n-Z$ where n = 1 to 4, where Z is H, alkyl, aryl,

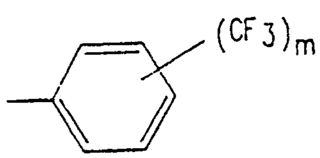

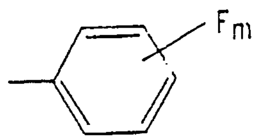

where m = 1 to 5, where X and Y (1) form a cyclic or polycyclic ring which may contain one or more hetero atoms, (2) form a fused aromatic ring, (3) may be independently H, alkyl or aryl, (4) may be attached to another sulfonyloxyimide-containing residue, or (5) may be attached to a polymeric chain or backbone.

The present invention takes advantage of the discovery that certain epoxide containing compounds which have at least 2 epoxy groups per molecule function in the presence of radiation generated acid to effectively and precisely crosslink hydroxy-substituted polymeric compounds such as novolak and poly(para - hydroxystyrene) resins.

In the examples which follow all parts and percentages given are by weight.

Example 1

A base developable negative-tone resist polymer composition was prepared by thoroughly mixing a polyhydroxystyrene polymer with epoxynovolak and then adding triphenylsulfonium hexafluoroantimonate, a radiation degradable acid generator composition to give a composition having the following solids composition:

| Component | Percent by weight |
|---|---|
| Polyhydroxystyrene | 77 |
| Epoxynovolak | 14 |
| Triphenylsulfonium hexafluoroantimonate | 9 |

The resist solids were dissolved in propylene glycol methyl ether acetate so that the final composition had 22% by weight solids. The resist composition was coated onto substrates and imaged using electron beam in one instance and deep UV in another. The patterned images formed in each instance by alkali development were of high resolution, showed no loss in sensitivity, and provided good contrast.

Example 2

Another base developable negative-tone resist polymer composition was prepared by thoroughly mixing a polyhydroxystyrene polymer with Araldite CY-179, a biscyclohexene epoxide, and then adding triphenylsulfonium hexafluoroantimonate, a radiation degradable acid generator composition to give a composition having the following solids composition:

| Component | Percent by weight |
|---|---|
| Novolak | 66 |
| Biscyclohexene epoxide | 17 |
| Triphenylsulfonium hexafluoroantimonate | 17 |

The resist solids were dissolved in propylene glycol methyl ether acetate so that the final composition had 22% by weight solids. The resist composition was coated onto substrates and imaged and printed using electron beam lithography to produce 0.5 µm lines in one instance and using x-ray lithography in another to produce 0.4 µm lines. The images were developed in aqueous base developer.

Example 3

Another polyhydroxy-styrene-epoxy novolak negative resist composition was prepared having the following compositions:

| Component | Percent By Weight |
|---|---|
| Polyhydroxystyrene | 87.8 |
| Epoxynovolak | 7.2 |
| Triphenylsulfonium hexafluoroantrimonate | 5.0 |

The resist solids were dissolved in propylene glycol methyl ether acetate giving a composition having approximately 22% solids. The resist coated onto substrates and was exposed in deep UV (200-290 nm) using an Oriel exposure tool. The exposure time was approximately 3 seconds followed by a post exposure bake at 100 °C for 1.5 minutes. The resulting images provided 3 µm lines with about 20% resist thinning and a contrast greater than 2.

Example 4

Another polyhydroxystyrene-epoxy novolak composition was prepared and sensitized with an onium salt as follows:

| Component | Percent By Weight |
| --- | --- |
| Polyhydroxystyrene | 83.2 |
| Epoxynovolak | 6.8 |
| Triphenylsulfonium hexafluoroantimonate | 10.0 |

The resist solids were dissolved in propylene glycol methyl ether acetate to provide a composition having approximately 22% solids. The resist was coated onto substrates and were exposed using an e-beam exposure tool with an exposure dose of 3µC/cm$^2$ at 25 KeV followed by a post exposure bake at 105° C for 15 minutes. The images were resolved using TMAH developer. The resultant images provide 0.5 um resolution with about 30% resist thinning.

Example 5

Another polyhydroxystyrene-epoxy novolak composition was prepared and sensitized with an onium salt as follows:

| Component | Percent By Weight |
| --- | --- |
| Polyhydroxystyrene | 81.0 |
| Epoxynovolak | 9.0 |
| Triphenylsulfonium hexafluoroantimonate | 10.0 |

The resist solids were dissolved in propylene glycol methyl ether acetate to provide a composition having approximately 22% solids. The resist was coated onto substrates and were exposed using an e-beam exposure tool with an exposure dose of 3 uC/cm$^2$ at 25 KeV followed by a post exposure bake at 105° C for 15 minutes. The images were resolved using TMAH developer. The resultant images provide 1.0 µm resolution with about 15% resist thinning.

Example 6

Another polyhydroxystyrene-epoxy novolak composition was prepared and sensitized with an onium salt as follows:

| Component | Percent By Weight |
| --- | --- |
| Polyhydroxystyrene | 72.0 |
| Epoxynovolak | 18.0 |
| Triphenylsulfonium hexafluoroantimonate | 10.0 |

The resist solids were dissolved in propylene glycol methyl ether acetate to provide a composition having approximately 22% solids. The resist was coated onto substrates and were exposed using an e-beam exposure tool with an exposure dose of 2 µC/cm$^2$ at 25 KeV. One group of substrates received a post exposure bake at 90° C for 5 minutes followed by TMAH which gave 1.0 µm resolution with about 15%

thinning while another group of substrates which received a post exposure bake at 105° C for 5 minutes provided 0.5 µm resolution with about 10% thinning.

Example 7

Another polyhydroxystyrene-epoxy novolak composition was prepared and sensitized with an onium salt as follows:

| Component | Percent By Weight |
|---|---|
| Polyhydroxystyrene | 71.1 |
| Epoxynovolak | 18.9 |
| Triphenylsulfonium hexafluoroantimonate | 10.0 |

The resist solids were dissolved in propylene glycol methyl ether acetate to provide a composition having approximately 22% solids. The resist was coated onto substrates and one group of substrates was exposed using an e-beam exposure tool with an exposure dose of 2 $\mu C/cm^2$ at 25KeV followed by a post exposure bake at 105° C for 5 minutes. The resultant images provided 0.5 µm resolution with about 10% resist thinning. A second group of substrates was exposed with an exposure dose of 6 $\mu C/cm^2$ at 25 KeV followed by a post exposure bake at 90° C for 5 minutes. The resultant images provided 0.5 µm resolution with about 10% resist thinning.

Example 8

Formulations were prepared using meta -cresol novolak resins and araldite CY-179, a biscyclohexene epoxide composition, and were sensitized with triphenyl sulfonium hexafluoroantimonate as follows:

| Component | Compositions | | | | |
|---|---|---|---|---|---|
| | A | B | C | D | E |
| m -Cresol novolak | 78 | 76 | 74 | 72 | 64 |
| Araldite CY-179 | 2 | 4 | 6 | 8 | 16 |
| Triphenylsulfonium hexafluoroantimonate | 20 | 20 | 20 | 20 | 20 |

The resist solids for each of compositions A-E were dissolved in propylene glycol methyl ether acetate to give compositions having approximately 22% solids. Substrates were coated with compositions A-E and were exposed using an e-beam exposure tool at exposure doses of 2.5 $\mu C/cm^2$ at 50 KeV and 0.5 $\mu C/cm^2$ at 10 KeV. Following post exposure baking at 105° C for 15 minutes, the substrates were developed in TMAH and 1 um lines and spaces were resolved for substrates of each composition at both dose intensities.

Additional substrates coated with these compositions were imaged using X-ray at 50mJ/cm². Following post exposure baking at 105° C for 15 minutes, these substates were developed in TMAH and 0.5 um lines and spaces were also resolved for each composition.

Example 9

Formulations were prepared using a meta -cresol novolak resin. Araldite® CY-179, a biscyclohexene epoxide composition, and were sensitized with triphenylsulfonyloxydicarboximide, a non-metallic, sulfonic acid precursor as follows:

| Component | Compositions Percent By Weight) | |
|---|---|---|
| | A | B |
| m -Cresol novolak | 72 | 76 |
| Araldite CY-179 | 18 | 19 |
| Triphenylsulfonyloxydicarboximide | 10 | 5 |

The resist solids for each composition were dissolved in propylene glycol methyl ether acetate to give compositions having approximately 22% solids. Substrates were coated with compositions A and B. The substrates were exposed in an e-beam tool at an exposure dose of 1-2 $\mu C/Cm_2$ at 25 KeY. The exposed substrates were subjected to post exposure baking at 105° C for 15 minutes and were then developed in TMAH to produce patterns resulting in 1.0 µm lines and spaces.

Example 10

A Bisphenol A novolak - Araldite CY-179 formulation is prepared and sensitized as follows:

| Compound | Percent by Weight |
|---|---|
| Bisphenol A-Novolak | 72 |
| Araldite CY-179 | 18 |
| Triphenylsulphonium-hexafluoroautimonate | 10 |

The resist solids are dissolved in propylene glycol methyl ether acetate to provide a composition having approximately 22% solids. The resist is then coated onto substrates and exposed on an e-beam exposure tool with an exposure dose of 2.5 $\mu C/Cm^2$ at 25 KeV followed by a part exposure bake at 105° C for 15 minutes. The substrates are developed in TMAH and 1.0 µm lines and spaces are resolved.

## Claims

1. An aqueous base developable resist composition comprising a hydroxy-substituted aromatic polymeric composition, a radiation degradable acid generator which is adapted to absorb imaging radiation, and a cross-linking agent having at least 2 epoxy groups per molecule.
2. The composition of claim 1 wherein the cross-linking agent is a cycloaliphatic compound.
3. The composition of claim 2 wherein the cycloaliphatic compound is a cyclohexene epoxide compound.
4. The composition of claim 1 wherein the cross-linking agent is a glycidyl ether compound.
5. The composition of claim 4 wherein the glycidyl ether compound is a partially epoxidized novolak resin.
6. The composition of claim 1 wherein the hydroxy-substituted aromatic polymeric composition comprises a novolak resin.
7. The composition of claim 6 wherein the novolak resin comprises a meta -cresol novolak.
8. The composition of claim 6 wherein the novolak resin comprises a bis-Phenol A novolak.
9. The composition of claim 1 wherein the hydroxy-substituted aromatic polymeric composition comprises a poly(para -hydroxystyrene).
10. The composition of claim 1 wherein the radiation degradable acid generator is selected from the group consisting of metallic onium salts and non-metallic sulfonic acid precursors which generate strong acids upon exposure to radiation.
11. The composition of claim 10 wherein the onium salt is selected from the group consisting of diaryliodonium salts and aryl sulfonium salts.
12. The composition of claim 11 wherein the diaryliodonium salt is selected from the group consisting of di-(tert -butylphenyl)iodonium triflate, di(tert -butylphenyl)iodonium hexafluoroarsenate, and di(tert -butylphenyl)iodonium hexafluoroantinonate.

13. The composition of claim 11 wherein the aryl sulfonium salt is selected from the group consisting of triphenylsulfonium hexafluoroantimonate, triphenylsulfonium hexafluoroarsinate, and triphenylsulfonium hexafluorophosphate.

14. The composition of claim 10 wherein the non-metallic sulfonic acid precursor is an N-sulfonyloxyimide of the form

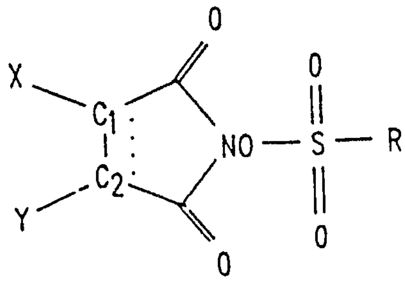

wherein R is selected from the group consisting of $-CF_3$, $-CF_2CF_3$, $-CF_2CF_2H$, $-(CF_2)-Z_n$ where n = 1 to 4, where Z is H, alkyl, aryl,

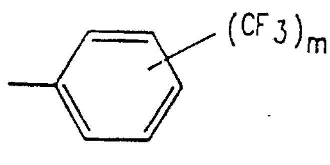

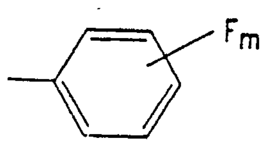

where m = 1 to 5, where X and Y (1) form a cyclic or polycyclic ring which may contain one or more hetero atoms, (2) form a fused aromatic ring, (3) may be independently H, alkyl or aryl, (4) may be attached to another sulfonyloxyimide-containing residue, or (5) may be attached to a polymeric chain or backbone.

15. The composition of claim 1 wherein the hydroxy-substituted polymeric composition comprises 70-90% by weight of the solids, the cross-linking agent having at least 2 epoxy groups per molecule comprises 5-20% by weight of the solids the radiation degradable acid generator comprises 5-20% by weight of the solids.